(19) Europäisches Patentamt
European Patent Office
Office européen des brevets

(11) EP 2 512 978 B1

(12) **EUROPEAN PATENT SPECIFICATION**

(45) Date of publication and mention
of the grant of the patent:
**19.08.2015 Bulletin 2015/34**

(51) Int Cl.:
*B81C 99/00* (2010.01)          *B01L 3/00* (2006.01)
*B29C 33/42* (2006.01)          *B29C 33/56* (2006.01)
*B29C 39/00* (2006.01)          *B29C 39/26* (2006.01)

(21) Application number: **09768532.5**

(22) Date of filing: **14.12.2009**

(86) International application number:
**PCT/EP2009/067082**

(87) International publication number:
**WO 2011/072713 (23.06.2011 Gazette 2011/25)**

(54) **CAST POLYMER LAYER WITH HIGH ASPECT RATIO**

GUSSPOLYMERSCHICHT MIT HOHEM ASPEKTVERHÄLTNIS

COUCHE POLYMÈRE MOULÉE AYANT UN RAPPORT DE FORME ÉLEVÉ

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**24.10.2012 Bulletin 2012/43**

(73) Proprietor: **SICPA HOLDING SA
1008 Prilly (CH)**

(72) Inventors:
• **CIAMPINI, Davide**
 **I-11020 Arnad (ao) (IT)**
• **VITALBO, Luigi**
 **I-11020 Arnad (ao) (IT)**

(74) Representative: **Hoffmann Eitle
Patent- und Rechtsanwälte PartmbB
Arabellastraße 30
81925 München (DE)**

(56) References cited:
• SETHU P ET AL: "Cast epoxy-based microfluidic systems and their application in biotechnology" SENSORS AND ACTUATORS B, ELSEVIER SEQUOIA S.A., LAUSANNE, CH LNKD- DOI: 10.1016/J.SNB.2003.09.036, vol. 98, no. 2-3, 15 March 2004 (2004-03-15), pages 337-346, XP004493696 ISSN: 0925-4005
• SONG QU ET AL: "Poly(methyl methacrylate) CE microchips replicated from poly (dimethylsiloxane) templates for the determination of cations" ELECTROPHORESIS, WILEY INTERSCIENCE, DE LNKD- DOI: 10.1002/ELPS.200600239, vol. 27, no. 24, 1 December 2006 (2006-12-01), pages 4910-4918, XP007915590 ISSN: 0173-0835 [retrieved on 2006-11-22]
• FIORINI G S ET AL: "Fabrication improvements for thermoset polyester (TPE) microfluidic devices" LAB ON A CHIP, ROYAL SOCIETY OF CHEMISTRY, CAMBRIDGE, GB LNKD- DOI: 10.1039/B702548C, vol. 4, no. 7, 1 July 2007 (2007-07-01), pages 923-926, XP007915589 ISSN: 1473-0197

**Description**

**FIELD OF THE INVENTION**

The present invention relates in general to a patterned polymer layer with high aspect ratio to be used in contact with biological solutions or fluids.

More particularly, the present invention relates to a patterned polymer layer, comprising a microstructure of grooves or wells delimited by walls with a high aspect ratio, i.e. with a ratio of height to thickness greater than or equal to five. The present invention relates also to a method of production of such a patterned polymer layer.

**PRIOR ART**

In the biomedical sector, devices are known for the filtration of biological solutions or biological fluids containing biological components, such as proteins, enzymes, antibodies, antigens, DNA, cells, platelets, and so on. Said devices comprise a series of grooves or wells of micrometric dimensions delimited by walls with a high aspect ratio.

Such devices are typically made by techniques of dry etching of substrates of silicon or of some other inorganic material.

For example, patent US 6,841,339 describes a process for the preparation of a micro-mold of silicon using a plasma anisotropic erosion process (Bosch process) described in US 5,501,893 or another process of the "etch-and-coat" type, in which the erosion process runs in parallel with a process of passivation, i.e. of protection, of the walls in the course of formation.

Patent US 5,256,360 describes the use of an EDM apparatus (EDM: electric discharge machining) to make a filter mold with a plurality of rod-like protrusions and suggests the use of techniques of laser-beam micro-machining or electron-beam micro-machining.

Alternatively, other techniques of micro-erosion are known for obtaining microstructures with high aspect ratio. For example, US 6,582,890 describes processes that use exposure to X-rays, known by the acronyms LIGA and SLIGA, from the German "Lithographische Galvanoformung Abformtechnik". These processes are critical owing to their cost and the danger of exposure of the operators to X-rays and a process is suggested for the preparation of a multilayer microstructure with high aspect ratio using a series of depositions and exposures of photosensitive layers, using a "lost" mold.

A first disadvantage of the devices made with the processes of the prior art is that the production techniques are very expensive.

Moreover, the devices produced on substrates of silicon or of some other inorganic material are very fragile and have poor mechanical properties, so that they are easily broken.

The surface of silicon or of inorganic material is, moreover, poorly wettable by water or aqueous solutions.

The devices made with these materials therefore require surface treatments with chemical agents, for example, polyethylene glycols and/or functionalizing agents, which may alter the geometry of the device, or with physical agents, such as plasma treatments based on nitrogen or forming gas, which do not guarantee their long-term durability. Such treatments can be difficult and expensive owing to the conditions in which they are carried out (high temperature, high vacuum). In the case of devices which are made by moulding it is common to coat the mould with a non-stick release layer, see SETHU P ET AL: "Cast epoxy-based microfluidic systems and their application in biotechnology", SENSORS AND ACTUATORS B, ELSEVIER SEQUOIA S.A., LAUSANNE, vol. 98, no. 2-3,15 March, pages 337-346.

Applicants have determined that the use of the techniques of polymerization molding, where a liquid monomer or prepolymer is poured into a mold and then polymerized, does not lend itself to the production of micrometric structures, because removal of the polymer from the mold is difficult and subject to breakage. Alternatively, in the case when dissolution of the mold is employed, the method becomes particularly expensive for microstructures with high aspect ratio, as it is necessary to make a mold for each device.

**SUMMARY OF THE INVENTION**

The applicant has found that the use of conventional materials and techniques does not meet the requirements imposed on modern devices for filtration of biological solutions or biological fluids.

The applicant in fact observed that devices for the filtration of biological solutions or biological fluids should be made of a material that is more resistant and less fragile, displaying good characteristics of intrinsic wettability, by a less expensive method.

The applicant has now found that it is possible to overcome the aforementioned disadvantages with a method of polymerization moulding that uses an acrylic and/or epoxy polymerizable material with a mold made of organic material, for example photosensitive polymer materials, or inorganic material, for example silicon or metals, whose surface has been treated with a suitable polymerization inhibitor.

The present invention therefore relates to a device according to claim 18, the device comprising a patterned polymer layer with high aspect ratio to be used in contact with biological solutions or fluids, as well as the method of production of said layer according to claim 1, comprising a phase of polymerization moulding that uses an acrylic and/or epoxy polymerizable material with a mold of organic or inorganic nature.

## BRIEF DESCRIPTION OF THE DRAWINGS

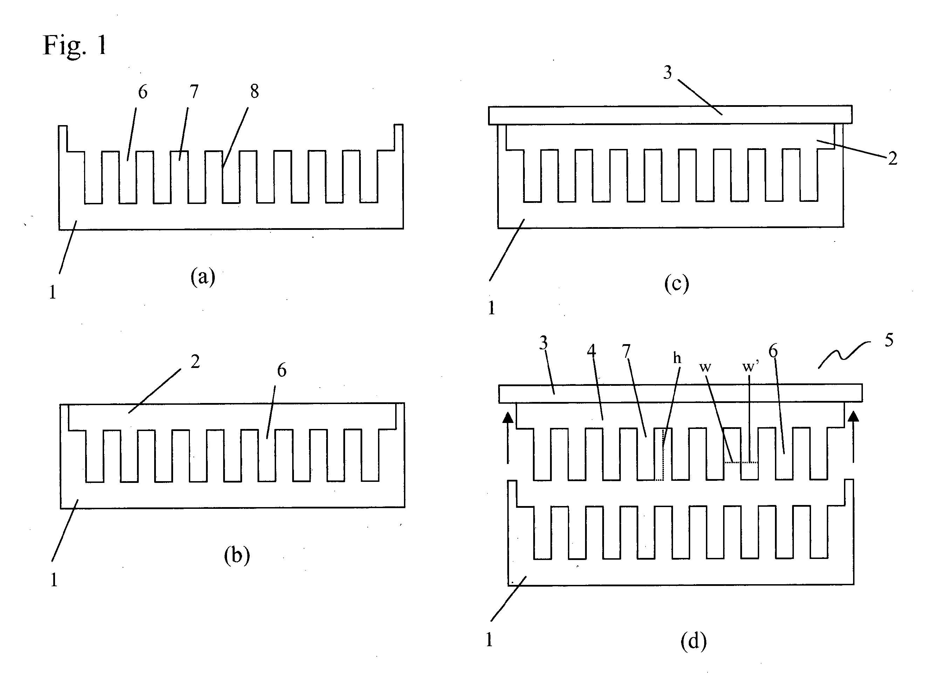

Fig. 1 shows a sectional view of the mold-polymerizable formulation-substrate system during the method of production of a patterned polymer layer according to the present invention, characterized by a series of parallel channels. Fig. 1(a) shows the empty mold, Fig. 1(b) shows the mold filled with the liquid polymerizable formulation, Fig. 1(c) shows the positioning of the substrate and polymerization, Fig. 1(d) shows separation of the substrate-patterned polymer layer system from the mold.

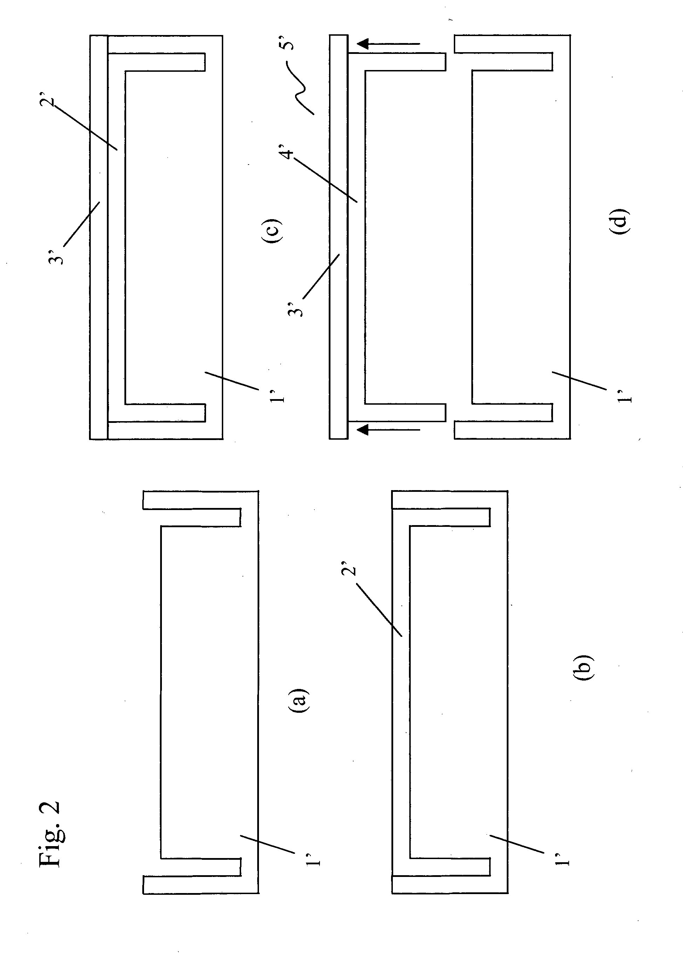

Fig. 2 shows a sectional view of the mold-polymerizable formulation-substrate system during the method of production of a different patterned polymer layer according to the present invention, represented by a cover for the patterned polymer layer of Fig. 1. Fig. 2(a) shows the empty mold, Fig. 2(b) shows the mold filled with the liquid polymerizable formulation, Fig. 2(c) shows the positioning of the substrate and polymerization, and Fig. 2(d) shows the separation of the substrate-patterned polymer layer system from the mold.

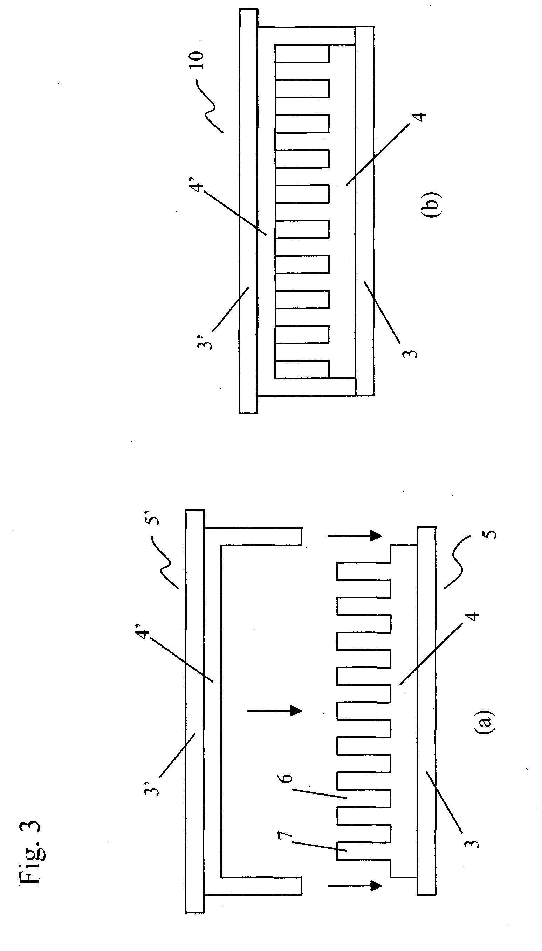

Fig. 3 shows a sectional view of the patterned polymer layer-cover system during the method of assembly. Fig. 3(a) shows assembly of the two components, and Fig. 3(b) shows the finished product.

## DETAILED DESCRIPTION OF THE INVENTION

The present invention relates to a device comprising a patterned polymer layer with high aspect ratio to be used in contact with biological solutions or fluids, as well as the method of production of said layer, comprising a phase of polymerization moulding that uses an acrylic and/or epoxy polymerizable material with a mold of organic or inorganic nature.

The patterned polymer layer obtained with the process of the present invention comprises a microstructure of grooves or wells delimited by walls with a high aspect ratio, i.e. with a ratio of height to width greater than or equal to five. The term microstructure refers to a three-dimensional structure having at least one dimension (height, width, or length) of micrometric dimensions, i.e., lower than 500 $\mu$m, preferably lower than 100 $\mu$m,

The molds for use in the present invention can be made of a considerable variety of materials. It is possible to use molds made of inorganic material, for example silicon and metal, or organic materials, for example photosensitive polymers (SU-8). Preferably, molds made of silicon are used.

The mold can be produced starting from a flat, smooth surface by various techniques, such as etching, hot embossing, laser, laser blasting, micromachining, and so on.

An example of a mold for structures with high definition can be constituted of a silicon wafer on which fine structures are produced by dry etching. Examples of methods for making the high-definition mold to be used in the process of the present invention are described in the aforementioned patents US 5,501,893 and US 6,841,339.

As shown in Fig. 2, if required, using the method of the present invention it is possible to produce, by means of suitably patterned molds 1', covers 4' for devices containing the microstructures mentioned above. These can be glued to the device so as to obtain device 10 for the filtration of biological solutions or biological fluids containing biological components, illustrated in Fig. 3. Device 10 comprises suitable inlet and outlet openings, not shown in Fig. 3, for feed and exit of the fluid to be filtered.

The formulation used for obtaining the patterned polymer layer with high aspect ratio can be acrylic or epoxy. Preferably, acrylic formulations are used, so as to obtain high polarity of the surface of the patterned polymer layer.

The type of formulation used has an influence on the process and the materials used for making the mold and the substrate as well as the process used for production of the patterned polymer layer of the present invention.

The formulation used must, after polymerization, provide a polymer material with very low adhesion to the surface of the mold, but with very high adhesion to the surface of the substrate. In this way it will be possible to separate the patterned polymer layer and the mold without causing breakages and/or defects in the finished article.

The applicant found that the use of the aforementioned acrylic and/or epoxy formulation makes it possible to obtain a patterned polymer layer with good antifouling properties, i.e. particularly resistant to the formation of scale, and biocompatible, i.e. without interactions with the biological fluids with which it comes in contact, without any release or absorption of components from the layer or from the biological fluid, respectively.

Therefore, the use of the acrylic and/or epoxy formulation means it is possible to avoid all surface treatments, such as thermal, corona, plasma treatments and so on, that are normally used for improving the antifouling properties and biocompatibility.

Furthermore, the applicant found that the use of the aforementioned acrylic and/or epoxy formulation makes it possible to obtain better wettability of the surface of the polymer layer.

The acrylic formulation preferably comprises a mixture of at least one polyol tri(meth)acrylate monomer, and at least one polyalkylene glycol mono(meth)acrylate monomer.

The polyol tri(meth)acrylate monomer is preferably selected from triacrylates such as ditrimethylolpropane triacrylate (DiTMPTTA), tris-(2-hydroxyethyl)-isocyanurate triacrylate (TEICTA), dipentaerythritol triacrylate (DiPETA), trimethylolpropane triacrylate ethoxylate (TMPEOTA), trimethylolpropane triacrylate propoxylate (TMPPOTA), pentaerythritol triacrylate ethoxylate (PETEOIA), glyceryl triacrylate propoxylate (GPTA), pentaerythritol triacrylate (PETA), trimethylolpropane triacrylate (TMPTA) and modified pentaerythritol triacrylate; and trimethacrylates such as triethyleneglycol trimethacrylate (TIEGTMA), tetraethylene glycol trimethacrylate (TTEGTMA), polyethylene glycol trimethacrylate (PEGTMA), trihydroxyhexane trimethacrylate (HTTMA), bisphenol A trimethacrylate ethoxylate, trimethylolpropane trimethacrylate (TMPTMA).

Polyol tri(meth)acrylate ethoxylate or propoxylate monomers are preferably used. The use of polyol tri(meth)acrylate ethoxylate or propoxylate monomers improves the wettability of the surface of the resultant patterned polymer layer of the present invention.

Moreover, the use of polyol tri(meth)acrylate ethoxylate or propoxylate monomers, normally liquid with low viscosity, permits the viscosity of the formulation to be reduced, so that there is then better filling of the microcavities of the mold.

The preferred polyol tri(meth)acrylate ethoxylate or propoxylate monomers include, but are not restricted to, trimethylolpropane triacrylate ethoxylate (TMPEOTA), trimethylolpropane triacrylate propoxylate (TMPPOTA), pentaerythritol triacrylate ethoxylate (PETEOIA), glyceryl triacrylate propoxylate (GPTA), bisphenol A trimethacrylate ethoxylate, and trimethylolpropane trimethacrylate ethoxylate (TMPETMA), commercially available for example from IGM Resins, with the tradename Omnimer™.

The acrylic formulation preferably comprises from about 40% to about 90%, by weight, based on the total weight of the acrylic formulation, of polyol tri(meth)acrylate ethoxylate or propoxylate monomers. According to a preferred embodiment, the acrylic formulation preferably comprises from about 50% to about 80%, by weight, based on the total weight of the acrylic formulation, of polyol tri(meth)acrylate ethoxylate or propoxylate monomers.

The polyalkylene glycol mono(meth)acrylate monomer is preferably selected from (meth)acrylates such as polypropylene glycol monomethacrylate, polyethylene glycol monomethacrylate, polyethylene glycol-polypropylene glycol monomethacrylate, polypropylene glycol monoacrylate, polyethylene glycol monoacrylate, polypropylene glycol polytrimethylene monoacrylate, polyethylene glycol polytetramethylene glycol monomethacrylate, methoxypolyethylene glycol monomethacrylate, perfluoroalkylethyl polyoxyalkylene monomethacrylate, and combinations thereof. The aforementioned (meth)acrylates are commercially available, for example, from Nippon Oils & Fats Co., with the tradename Blemmer PP series (polypropylene glycol monomethacrylates), Blemmer PE series (polyethylene glycol monomethacrylates), Blemmer PEP series (polyethylene glycol-polypropylene glycol monomethacrylates), Blemmer AP-400 (polypropylene glycol monoacrylate), and Blemmer AE-350 (polyethylene glycol monoacrylate).

The acrylic formulation preferably comprises from about 5% to about 35%, by weight, based on the total weight of the acrylic formulation, of polyalkylene glycol mono(meth)acrylate monomers. In a preferred embodiment, the acrylic formulation preferably comprises from about 10% to about 30%, by weight, based on the total weight of the acrylic formulation, of polyalkylene glycol mono(meth)acrylate monomers.

The epoxy formulation can comprise any polymerizable epoxy resin known in the art, such as the reaction products of condensation of epichlorohydrin with polyalcohols or polyphenols (in particular bisphenol A), cycloaliphatic epoxy resins, epoxy resins derived from diolefins or polyolefins or a copolymer thereof, composite epoxy resins obtained by copolymerization with glycidyl-methacrylate, epoxy resins obtained from glycerides of unsaturated fatty acids, and so on.

The epoxy formulation preferably comprises (i) cycloaliphatic epoxy resins, for example, 2,4-epoxycyclohexylmethyl-(3,4-epoxy)cyclohexane carboxylate (ERL4221™, Union Carbide Plastics Company, or Araldite™CY179, Ciba Products Company), 3,4-epoxycyclohexylmethyl-(3,4-epoxy)cyclohexane carboxylate (Cyracure™UVR-6105, Dow Chemical), bis(3,4-epoxy-6-methylcyclohexylmethyl) adipate (ERL4289™, Union Carbide Plastics Company, Araldite™CY178, Ciba Products Company), bis(3,4-epoxycyclohexylmethyl) adipate, (EHPE3150, Daicel Chemical Industries), vinylcyclohexene dioxide (ERL4206™, Union Carbide Plastics Company), bis(2,3-epoxycyclopentyl) ether resin (ERL4205™, Union Carbide Plastics Company), 2-(3,4-epoxy)cyclohexyl-5,5-spiro(3,4-epoxy)-cyclohexane-m-dioxane (Araldite™ CY175, Ciba Products Company), (ii) epoxy resins of polyphenolic glycidyl ethers, for example, diglycidyl ether bisphenol A epoxy resins (Epon™826, Epon™828, Epon™830, Epon™1001, Epon™1002, Epon™1004, Shell Chemical Company), polyglycidyl ether novolac epoxy resins (DEN™431, DEN™438, and DEN™439, Dow Chemical Company); (iii) epoxy resins of glycidyl esters, for example diglycidyl phthalate (ED-5661, Celanese Resins Company), diglycidyl tetrahydrophthalate (Araldite™CY182, Ciba Products Company) and diglycidyl hexahydrophthalate (Araldite™CY183, Ciba Products Company or ED-5662, Celanese Resins Company); and mixtures thereof.

Polymerization of the acrylic and/or epoxy formulation can take place according to methods that are known in the art, for example thermally and/or photochemically. Preferably polymerization takes place photochemically. If the substrate is not transparent to radiation, it will be necessary to use thermal initiators instead of photoinitiators for promoting polymerization of the formulation.

The acrylic and/or epoxy formulation comprises from about 1 % to about 25%, more preferably from about 2% to about 20 wt.% relative to the total weight of the formulation, of a thermal initiator or an initiator that is sensitive to UV and/or blue radiation (photoinitiator). The term "photoinitiator" denotes a compound that is able to convert the energy of blue and/or UV radiation to free radicals. The term "thermal initiator" denotes a compound that is able to convert thermal energy to free radicals. The presence of free radicals starts a chain reaction that converts the reactive monomer to oligomers, and finally to polymers.

Examples of suitable photoinitiators include, but are not restricted to, 2,2'-(2,5-thiophenediyl)bis(5-tert-butylbenzoxazole); 1-hydroxycyclohexyl phenyl ketone; 2,2-dimethoxy-2-phenylacetophenone; xanthone; fluorenone; anthraquinone; 3-methylacetophenone; 4-chlorobenzophenone; 4,4'-dimethoxybenzophenone; 4,4'-diaminobenzophenone; Michler's ketone; benzophenone; benzoin propyl ether; benzoin ethyl ether; benzyl dimethyl ketal, 1-(4-isopropylphenyl)-2-hydroxy-2-methylpropan-1-one; 2-hydroxy-2-methyl-1-phenylpropan-1-one; methylbenzoyl formate thioxanthone; diethylthioxanthone; 2-isopropylthioxanthone; 2-chlorothioxanthone; 2-methyl-1-(4- (methylthio)phenyl)-2-morpholinopropan-1-one; and 2,4,6-trimethylbenzoyldiphenylphosphine oxide.

Preferably, multifunctional photoinitiators are used in the acrylic formulation. Examples of suitable multifunctional photoinitiators include, but are not restricted to, Esacure KIP 100 (a mixture of 70 wt.% of an oligomeric $\alpha$-hydroxy acetophenone and 30 wt.% of dimethyl hydroxy acetophenone), KIP 150, Esacure KTO-46 (mixture of trimethylbenzophenone, polymeric hydroxy ketone, and trimethylbenzoyldiphenyl phosphine oxide), and Esacure ONE ($\alpha$-hydroxyketone bifunctional photoinitiator), all commercially available from Lamberti S.p.A., Gallarate, Italy).

Advantageously, suitable thermal initiators include, but are not restricted to, organic peroxides such as diacyl peroxides, peroxybicarbonates, alkyl peresters, dialkyl peroxides, perketals, ketone peroxides and alkyl hydroperoxides, and azo compounds. Specific examples of said thermal initiators are dibenzoyl peroxide, t-butyl perbenzoate, t-butyl peroxide, methyl ethyl ketone peroxide, and azobisisobutyron itrile.

Preferably, photoinitiators of the cationic type are used in the epoxy formulation. The use of cationic photoinitiators is preferred because photoinitiators of this type are not sensitive to oxygen and the reaction can be carried out in normal atmospheric conditions. The cationic photoinitiators are selected from those that release a Lewis acid or a Brønsted acid on irradiation, for example aryldiazonium salts, diaryliodonium salts, triaryl sulphonium salts, dialkyl phenacyl sulphonium salts, dialkyl-4-hydroxyphenyl sulphonium salts, Fe-arene compounds, and silanol-aluminium complexes. The preferred examples of aromatic photoinitiators are aromatic iodonium salts and aromatic sulphonium salts, for example, triarylsulphonium hexafluorophosphate (Cyracure™UVI-6992, Dow Chemical Company), triarylsulphonium hexafluorophosphate (Cyracure UVI-6976, Dow Chemical Company), and arylsulphonium hexafluorophosphate (Esacure 1064, Lamberti, Italy).

The patterned polymer layer according to the present invention is preferably attached to a substrate. Adhesion between the patterned polymer layer and the substrate is effected during polymerization of the acrylic or epoxy formulation.

The substrate for use in the present invention can be constituted from a variety of materials, such as silicon, polymers (PMMA, PC, COC, COP, and PS), photopolymers such as SU8 (MicroChem Corp.), Ordyl SY314 (Elga Europe), and TMMR 2000 (Tokyo Ohka Kogyo Co.) and metals such as aluminium, copper, tantalum, and nickel. The substrate has the function of providing support for the patterned polymer layer, by developing strong adhesion with said layer.

During the final phase of separation of the patterned polymer layer from the mold, the strength of adhesion of the polymer layer with respect to the substrate must be greater than that developed with respect to the mold.

Preferably, to reduce costs and for better adhesion, a substrate of polymethylmethacrylate (PMMA) is used.

Preferably, the substrate is transparent to UV and/or blue radiation, to permit polymerization by means of the aforementioned photoinitiators. If the substrate is not transparent to UV and/or blue radiation, advantageously thermal initiators will be used to promote the polymerization of the formulation.

The process of the present invention comprises;

(a) a surface treatment of a mold previously formed,
(b) pouring of the liquid polymerizable formulation in the mold,
(c) optionally, a surface treatment of a substrate,
(d) positioning of said substrate on the liquid polymerizable formulation,
(e) polymerization of the liquid polymerizable formulation, and
(f) separation of the mold from the patterned polymer layer.

Advantageously, the mold and the substrate undergo surface treatments.

The purpose of the surface treatment is to modify the characteristics of adhesion of the polymerized formulation with respect to the mold and to the substrate.

The surface treatment carried out on the mold has the purpose of reducing the adhesion of the polymerized formulation to the surface of the mold.

In the case of acrylic formulations, whose polymerization is inhibited by the presence of oxygen, a layer of molecular oxygen is physisorbed (i.e., made to undergo physisorption or physical adsorption) on the surface of the mold by various techniques, including a low-power oxygen plasma treatment.

Advantageously, formation of the layer of molecular oxygen on the surface of the mold inhibits the polymerization of the acrylic formulation at the interface with the surface of the mold, reducing the adhesion of the patterned polymer layer to the mold and favoring its removal.

Advantageously, formation of the layer of molecular oxygen on the surface of the mold also makes said surface more polar, improving the wettability of the liquid acrylic formulation with respect to the surface and consequently improving the filling of the microcavities of the mold.

In the case of epoxy formulations, the surface of the mold is treated in various ways depending on the type of polymerization used. In the case of anionic polymerization, the surface of the mold is treated with a plasma of Lewis acids, such as $BF_3$. In the case of cationic polymerization, the surface of the mold is treated with aminosilanes or ammonia.

Conversely, the surface treatment performed on the substrate has the purpose of increasing the adhesion of the polymerized formulation to the surface of the substrate.

In the case of acrylic formulations, the surface of the substrate is submitted to a plasma treatment with nitrogen, forming gas, or rare gases (avoiding the use of oxygen).

In the case of epoxy formulations, the surface of the substrate is treated in various ways depending on the type of polymerization used. In the case of cationic polymerization, the surface of the substrate is treated with a plasma of rare gases or oxygen, avoiding the use of plasmas containing nitrogen (forming gas or nitrogen). In the case of anionic polymerization, the surface of the substrate can be treated with a plasma of rare gases or oxygen, but also with a plasma of forming gas or nitrogen.

In the case when the substrate is polymeric (for example PMMA or PC), increase in adhesion between polymer layer and substrate can be promoted with suitable solvents which, when introduced in the formulation, attack the surface of the polymer material of the substrate, promoting migration of the monomers of the formulation into said substrate.

Advantageously, the presence of suitable solvents in the formulation promotes, in the pouring phase, migration of the monomers within the substrate. During the subsequent polymerization phase, a very high strength of adhesion develops between polymer layer and substrate, as the interface between the two materials disappears.

Advantageously, the formulations then comprise organic solvents of various kinds, such as ketones (acetone, methyl ethyl ketone), alcohols (ethanol, methanol), hydrocarbons (benzene, hexane), sulphoxides (dimethylsulphoxide).

The phase of pouring of the liquid polymerizable formulation in the mold comprises the complete filling of the microhydraulic system, i.e. of the microchannels and of the microcavities, of the mold.

To promote complete filling, the phase of pouring of the liquid polymerizable formulation is advantageously carried out at temperatures between 30°C and 120°C, preferably between 50°C and 100°C, more preferably between 60°C and 90°C. In this way the liquid polymerizable formulation is more fluid, i.e. has a lower viscosity, and the wettability of the walls of the mold is improved, also as a result of the previous surface treatment of the mold. In the case when the use of solvents is envisaged, for the purposes described above, the pouring phase is advantageously carried out at room temperature, to avoid excessive evaporation of said solvent.

In the pouring phase, normally the use of a slight excess of liquid polymerizable formulation is envisaged, which will then overflow from the edge of the mold so as to guarantee complete filling of the mold and perfect contact of the surface of the liquid polymerizable formulation with the substrate in the subsequent phase of positioning of the substrate.

The substrate, optionally treated as described previously, is positioned on the surface of the liquid polymerizable formulation in such a way that the surface of the substrate is completely in contact with the surface of the polymerizable formulation.

In this way, if the substrate is of plastic material and the formulation comprises an organic solvent, the solvent will start to attack the surface of the substrate, with consequent migration of the monomers of the polymerizable formulation within the substrate. To promote the action of the organic solvent, the mold-formulation-substrate system is heated, for example by means of a hot plate.

In general, the polymerization phase is carried out by exposure to UV-blue radiation or thermally.

Advantageously, the polymerization phase is carried out by exposure to radiation with a wavelength in the UV-blue range, i.e. from 200 to 500 nanometers. The energy of the UV-blue radiation is absorbed by a photoinitiator, which is able to convert light energy to free radicals. The presence of free radicals starts a chain reaction that converts the monomers to oligomers and finally to polymers.

In some cases, for example when the substrate is not transparent to UV-blue radiation, the polymerization phase can be carried out by thermal treatment. In this case a thermal initiator is preferably added to the polymerizable formulation. The polymerization temperature depends primarily on the decomposition temperature of the thermal initiator, but is preferably below 135°C, and in particular below 110°C.

It is also possible to use a combination of the two polymerization systems, photochemical and thermal. In this case the thermal phase is preferably carried out after the photochemical phase.

The resultant polymer will copy the surface of the mold, forming the negative of the structures made on said mold.

As mentioned previously, the use of acrylic and/or epoxy polymerizable material gives better wettability of the surface of the resultant patterned polymer layer.

The wettability of the surface of the patterned polymer layer of the present invention, when measured by the contact angle method using a water drop in contact with the surface, is less than or equal to 50°, preferably less than 40°, and more preferably less than 35°. The method comprises measurement of the angle formed between the surface of the patterned polymer layer and the tangent to the water drop at the point of contact. The water drop has a volume of about 5 ml and the measurement is carried out by measuring the width and the height of the projection of the drop enlarged on a screen, and applying the formula:

$$\alpha = 2\ arctan\ \frac{2h}{D}$$

where $\alpha$ is the contact angle in degrees, h is the height of the drop in mm, and D is the diameter of contact of the drop in mm.

The separation phase comprises the removal of the mold from the patterned polymer layer of the present invention.

Mold removal is carried out mechanically, by applying a pulling force on the substrate, after carrying out some thermal cycles of heating/cooling which, exploiting the different thermal expansion of the materials constituting the mold and the substrate, cause and promote the process of detachment between the polymer layer and the mold.

Advantageously, to promote the process of separation between the polymer layer and the mold, at least one thermal cycle is carried out, preferably at least three, each cycle being carried out by first heating at a temperature above 50°C, preferably between 60°C and 100°C, more preferably about 80°C, and then cooling to a temperature below 30°C, preferably to room temperature.

For making the complete removal of the mold, it is possible to use separating systems of the mechanical type, where the two surfaces, initially joined together, can be separated without damaging the microstructure obtained. The patterned polymer layer, which will have a form that represents the negative of the structure produced in the mold, will remain on the substrate. Any residues of crosslinked polymer inside the mold can be removed with plasma treatments.

Advantageously, the patterned polymer layer of the present invention is thus obtained at very low cost.

Preferably, the patterned polymer layer of the present invention has an aspect ratio greater than five, preferably greater than ten, and more preferably greater than twenty. The aspect ratio is defined, as is known by a person skilled in the art, as the ratio of the height to the width of a structure. Referring to Fig. 3, in the patterned polymer layer 4 of the present invention, the aspect ratio is defined as the ratio of the height of the groove 6 or of the wall 7 to their respective width.

The patterned polymer layer of the present invention comprises a microstructure having at least one dimension (height, width, or length) of micrometric dimensions, i.e., lower than 500 $\mu$m, preferably lower than 100 $\mu$m. Preferably, the patterned polymer layer of the present invention comprises a microstructure having at least two dimensions (height and width) of micrometric dimensions, i.e., lower than 500 $\mu$m, preferably lower than 100 $\mu$m. Referring to Fig. 3, in the patterned polymer layer 4 of the present invention, the height (h) of the groove 6 or of the wall 7 is lower than 500 $\mu$m, preferably lower than 200 $\mu$m, and more preferably between 1 and 100 $\mu$m; the width (w or w') of the groove 6 or of the wall 7 is lower than 500 $\mu$m, preferably lower than 100 $\mu$m, and more preferably between 1 and 50 $\mu$m.

The same degree of definition can only be obtained with techniques of dry etching on silicon or inorganic materials at high cost, where the final surface properties are closely linked to the type of process used for making the cavities, and require further treatments to make them wettable and biocompatible.

The definition achievable with the process of the present invention is closely correlated only with the limits of definition of the mold used. Advantageously, the process of the present invention makes it possible to produce a patterned polymer layer with a very high aspect ratio at low cost. This could not be achieved with the ordinary photolithographic techniques.

Moreover, the patterned polymer layer of the present invention possesses intrinsically, because of the nature of the material from which it is made, the surface characteristics of wettability, antifouling properties, and biocompatibility that are required for the biomedical applications for which it is intended, without the need to submit it to further surface treatments, which would increase the cost.

Finally, the mold, made by rather expensive techniques, can be reused to make successive copies, which helps to keep down the costs of production of the patterned polymer layer of the present invention.

Furthermore, the mechanical properties of the patterned polymer layer of the present invention prove to be far better - since the polymer is less fragile than the inorganic materials (for example silicon) it is not susceptible to breakage or damage during any subsequent processes or during the service life of the article.

A preferred embodiment of the invention is described below with reference to Figs. 1-3.

Referring to Fig. 1(a), a mold 1 is shown, comprising a series of channel-patterned grooves 6 separated by walls 7. The mold 1 was preferably obtained by dry etching of silicon by techniques known by a person skilled in the art. The inside surface 8 of the mold has undergone low-power oxygen plasma treatment with formation of a layer of molecular oxygen physisorbed on said surface 8.

Referring to Fig. 1(b), the mold 1 is shown, in which the appropriate amount of liquid polymerizable formulation 2 was poured into the mold 1 so as to fill all the channel-patterned grooves 6 and the entire mold 1. The liquid polymerizable formulation 2 can have the composition described previously. In particular, the formulations shown in Table 1 below were used. Pouring was carried out at room temperature.

Next, referring to Fig. 1(c), a substrate 3 was positioned on the mold so as to match the edges of the mold 1 and the surface of the liquid polymerizable formulation 2. Advantageously, substrate 3 was made of PMMA, and the liquid polymerizable formulation 2 comprised dimethyl sulphoxide. The presence of dimethyl sulphoxide in the liquid polymerizable formulation 2 promoted the migration of the monomers within the substrate, and the development of high strength of adhesion between polymer layer and substrate during the subsequent polymerization phase. The mold-substrate system is heated on a hot plate at temperatures between 40°C and 130°C, preferably between 80°C and 90°C. When using plastic material, such as, for example PMMA, the temperature is chosen to avoid any first order transition (fusion, crystallization) and/or any second order transition (glass transition). PMMA can be heated up to 120°C, beyond that the material start to soften and to warp.

Then the liquid polymerizable formulation 2 was polymerized by exposure to UV radiation with wavelength of about 320 nm, thus forming the patterned polymer layer 4 illustrated in Fig. 1(d). The device 5, constituted of the substrate 3 to which the patterned polymer layer 4 still adheres, was extracted from the mold by exerting a pulling force on the substrate. To promote the process of separation between the polymer layer and the mold, 3 thermal cycles of heating to about 80°C and then cooling to room temperature were carried out.

As shown in Fig. 2, using the procedure and materials similar to those described for Fig. 1, a cover 5' was made, constituted of a substrate 3' and a patterned polymer layer 4' obtained by polymerization of a liquid polymerizable formulation 2' suitably poured in a mold 1'.

The device 5 and the cover 5' are then assembled as shown in Fig. 3(a), thus obtaining the finished product 10 shown schematically in Fig. 3(b). Cover 5' was joined to device 5 by techniques known by a person skilled in the art, using adhesive or by means of ultrasound or techniques of solvent bonding, thermocompression, or laser welding.

Table 1 given below lists the acrylic liquid formulations used for production of the patterned polymer layer of the present invention. All of the values are expressed in percentages by weight relative to the total weight of the formulation.

TABLE 1

| Components | 1 | 2 | 3 |
|---|---|---|---|
| Trimethylol propane ethoxylate triacrylate | 65.7 | 65.7 | 60.7 |
| PEG methacrylate | 10 | 10 | 10 |
| Dimethyl sulphoxide | 20 | 20 | 20 |
| Tego®Rad 2300N | 0.3 | 0.3 | 0.3 |
| Esacure KIP 150 | 4 | 0 | 0 |
| Esacure KIP 100F | 0 | 4 | 0 |
| Esacure KTO 46 | 0 | 0 | 9 |

Tegorad 2300N Silicone polyether acrylate, Evonik Tego Chemie GmbH
Esacure KIP 150 Polyfunctional oligomeric $\alpha$-hydroxyketone, Lamberti S.p.A., Gallarate, Italy
Esacure KIP 100F Mixture of oligo [2-hydroxy-2-methyl-1-[4-(1-methylvinyl)phenyl]propanone] and 2-hydroxy-2-methyl-1-phenyl propan-1-one, Lamberti S.p.A., Gallarate, Italy
Esacure KTO 46 Mixture of trimethylbenzophenone, polymeric hydroxy ketone, and trimethylbenzoyldiphenyl phosphine oxide, Lamberti S.p.A., Gallarate, Italy

The next Table 2 lists some epoxy liquid formulations used for production of the patterned polymer layer of the present invention. All of the values are expressed in percentages by weight relative to the total weight of the formulation.

TABLE 2

| Components | 4 | 5 | 6 |
|---|---|---|---|
| Cyracure 6105 | 0 | 0 | 88.09 |
| EHPE 3150 | 71.41 | 71.41 | 0 |
| Aldrich 654027 | 10 | 0 | 2.5 |
| Esacure 1064 | 0 | 10 | 0 |
| Cyclopentanone | 18.55 | 18.55 | 9.22 |
| Byk 310 | 0.035 | 0.035 | 0.19 |

Cyracure 6105 3,4-Epoxycyclohexylmethyl-(3,4-epoxy) cyclohexane carboxylate, Dow Chemical
EHPE 3150 bis(3,4-Epoxycyclohexylmethyl) adipate, Daicel Chemical Industries
Aldrich 654027 Triarylsulphonium hexafluoroantimonate in propylene carbonate (1:1), Sigma-Aldrich
Esacure 1064 Arylsulphonium hexafluorophosphate, Lamberti, Italy
Byk 310 Dimethyl siloxane modified polyester, Byk Chemie

**Claims**

1. Method of production of a patterned polymer layer (4,4') adhering to a substrate (3,3'), comprising the steps of:

    (a) surface treating a previously formed mold (1,1') with a polymerization inhibitor,
    (b) pouring of an acrylic and/or epoxy liquid polymerizable formulation (2,2') in the mold (1,1'),
    (c) positioning a substrate (3,3') on the liquid polymerizable formulation (2,2'),
    (d) polymerizing the liquid polymerizable formulation (2,2'), and
    (e) separating the mold (1,1') from the patterned polymer layer (4,4').

2. The method of claim 1, further comprising (f) surface treating the substrate (3,3').

3. The method of claim 1, wherein the liquid polymerizable formulation (2,2') is acrylic, and step (a) comprises the formation of a layer of molecular oxygen physically absorbed on the surface of the mold.

4. The method of claim 3, wherein step (a) comprises a low-power oxygen plasma treatment.

5. The method of claim 1, wherein the liquid polymerizable formulation (2,2') is epoxy, and step (a) comprises treatment with a plasma of Lewis acids, with amino silanes, or with ammonia.

6. The method of claim 2, wherein the liquid polymerizable formulation (2,2') is acrylic, and step (f) comprises a plasma treatment with nitrogen, forming gas, or rare gases.

7. The method of claim 2, wherein the liquid polymerizable formulation (2,2') is epoxy, and step (f) comprises treatment with a plasma of rare gases, oxygen, forming gas or nitrogen.

8. The method of claim 1, wherein the substrate (3,3') is made of polymeric material.

9. The method of claim 8, wherein the liquid polymerizable formulation (2,2') comprises at least one organic solvent selected from ketones, alcohols, hydrocarbons and sulfoxides.

10. The method of claim 1, wherein step (b) is carried out at a temperature of between 30-120°C, preferably between 50-100°C, more preferably between 60-90°C.

11. The method of claim 9, wherein step (b) is carried out at room temperature.

12. The method of claim 11, wherein during step (c), the system comprising the mold, the formulation and the substrate is heated to a temperature of between 40-130°C, preferably between 80-90°C.

13. The method of claim 1, wherein step (d) is carried out by exposure to UV-blue radiation, by a thermal method, or by a combination thereof.

14. The method of claim 13, wherein step (d) is carried out by exposure to UV-blue radiation with a wavelength of 200-500 nm in the presence of a photoinitiator.

15. The method of claim 13, wherein step (d) is carried out by thermal treatment in the presence of a thermal initiator at a temperature below 135°C.

16. The method of claim 1, wherein step (e) is carried out mechanically after at least one thermal cycle.

17. The method of claim 16, wherein the thermal cycle is carried out by first heating to > 50°C, and then cooling to < 30°C, and preferably by first heating to a temperature between 60-100°C and then cooling to room temperature.

18. A device (5,5',10) comprising at least one patterned polymer layer (4,4') adhering to a substrate (3,3') and being suitable for use in contact with biological solutions or fluids, wherein the patterned polymer layer (4,4') comprises a microstructure of grooves or wells delimited by walls with an aspect ratio of > 5 and wherein the at least one patterned polymer layer (4,4') adhering to a substrate (3,3') is made by polymerization of an acrylic and/or epoxy polymerizable material according to the method of any one of claims 1-17.

19. The device of Claim 18, wherein the surface of the patterned polymer layer has a wettability of $\leq 50°$, preferably < 40°, measured by the contact angle method using a water drop in contact with the surface.

20. The device of Claim 18, wherein the patterned polymer layer (4,4') comprises a microstructure of grooves or wells delimited by walls with an aspect ratio of > 10, preferably > 20.

21. The device of Claim 18, wherein the acrylic polymerizable material comprises a mixture of at least one polyol tri(meth)acrylate monomer, and at least one polyalkylene glycol mono(meth)acrylate monomer.

22. The device of Claim 21, wherein the polyol tri(meth)acrylate monomer is selected from polyol tri(meth)acrylate ethoxylate and propoxylate monomers.

23. The device of Claim 22, wherein the polyol tri(meth)acrylate monomer is selected from trimethylolpropane triacrylate ethoxylate (TMPEOTA), trimethylolpropane triacrylate propoxylate (TMPPOTA), pentaerythritol triacrylate ethoxylate (PETEOIA), glyceryl triacrylate propoxylate (GPTA), bisphenol A trimethacrylate ethoxylate, and trimethylolpropane trimethacrylate ethoxylate (TMPETMA).

24. The device of Claim 21, wherein the polyalkylene glycol mono(meth)acrylate monomer is selected from polypropylene glycol monomethacrylate, polyethylene glycol monomethacrylate, polyethylene glycol-polypropylene glycol monomethacrylate, polypropylene glycol monoacrylate, polyethylene glycol monoacrylate, (polypropylene glycol polytrimethylene monoacrylate, polyethylene glycol polytetramethylene glycol monomethacrylate, methoxypolyethylene glycol monomethacrylate, perfluoroalkylethyl polyoxyalkylene monomethacrylate, and combinations thereof.

25. The device of Claim 18, wherein the epoxy polymerizable material comprises (i) cycloaliphatic epoxy resins, (ii) epoxy resins of polyphenol ic glycidyl ethers, epoxy resins of glycidyl esters, or mixtures thereof.

26. The device of Claim 25, wherein the cycloaliphatic epoxy resins are selected from 2,4-epoxycyclohexylmethyl-(3,4-epoxy)cyclohexane carboxylate, 3,4-epoxycyclohexylmethyl-(3,4- epoxy)cyclohexane carboxylate, bis(3,4-epoxy-6-methylcyclohexylmethyl) adipate, bis(3,4-epoxycyclohexylmethyl) adipate, vinylcyclohexene dioxide, bis(2,3-epoxycyclopentyl) ether resin, 2-(3,4-epoxy)cyclohexyl-5,5-spiro(3,4-epoxy)-cyclohexane-m-dioxane, and mixtures thereof.

27. The device of Claim 18, wherein the acrylic and/or epoxy polymerizable material comprises 1-25 wt.% relative to the total weight, of at least one thermal initiator or at least one photoinitiator sensitive to UV and/or blue radiation.

28. The device of Claim 27, wherein the acrylic polymerizable material comprises at least one multifunctional photoinitiator.

29. The device of Claim 27, wherein the epoxy polymerizable material comprises at least one cationic photoinitiator selected from aromatic iodonium salts and aromatic sulphonium salts.

30. The device of Claim 18, wherein the substrate is made of at least one material selected from silicon, polymers, photopolymers, and metals.

**Patentansprüche**

1. Verfahren zur Herstellung einer auf einem Substrat (3,3') haftenden strukturierten Polymerschicht (4,4'), umfassend die Schritte:

   (a) Oberflächenbehandlung einer vorher gebildeten Form (1,1') mit einem Polymerisations-inhibitor,
   (b) Eingießen einer auf Acryl und/oder Epoxid basierenden flüssigen polymerisationsfähigen Formulierung (2,2') in die Form (1,1'),
   (c) Positionierung eines Substrats (3,3') auf der flüssigen polymerisationsfähigen Formulierung (2,2'),
   (d) Polymerisation der flüssigen polymerisationsfähigen Formulierung (2,2') und
   (e) Abtrennung der Form (1,1') von der strukturierten Polymerschicht (4,4').

2. Verfahren nach Anspruch 1, ferner umfassend (f) Oberflächenbehandlung des Substrats (3,3').

3. Verfahren nach Anspruch 1, bei dem die flüssige polymerisationsfähige Formulierung (2,2') auf Acryl basiert und Schritt (a) die Bildung einer Schicht von molekularem Sauerstoff in physikalischer Absorption auf der Oberfläche der Form umfasst.

4. Verfahren nach Anspruch 3, bei dem Schritt (a) eine bei geringer Leistung erfolgende Sauerstoff-Plasmabehandlung umfasst.

5. Verfahren nach Anspruch 1, bei dem die flüssige polymerisationsfähige Formulierung (2,2') auf Epoxid basiert und Schritt (a) Behandlung mit einem Plasma aus Lewissäuren, mit Aminosilanen oder mit Ammoniak umfasst.

6. Verfahren nach Anspruch 2, bei dem die flüssige polymerisationsfähige Formulierung (2,2') auf Acryl basiert und Schritt (f) eine Plasmabehandlung mit Stickstoff, Formiergas oder Edelgasen umfasst.

7. Verfahren nach Anspruch 2, bei dem die flüssige polymerisationsfähige Formulierung (2,2') auf Epoxid basiert und Schritt (f) Behandlung mit einem Plasma aus Edelgasen, Sauerstoff, Formiergas oder Stickstoff umfasst.

8. Verfahren nach Anspruch 1, bei dem das Substrat (3,3') aus polymerem Material hergestellt wird.

9. Verfahren nach Anspruch 8, bei dem die flüssige polymerisationsfähige Formulierung (2,2') mindestens ein unter Ketonen, Alkoholen, Kohlenwasserstoffen und Sulfoxiden ausgewähltes organisches Lösungsmittel umfasst.

10. Verfahren nach Anspruch 1, bei dem Schritt (b) bei einer Temperatur zwischen 30-120°C, bevorzugt zwischen 50-100°C und besonders bevorzugt zwischen 60-90°C erfolgt.

11. Verfahren nach Anspruch 9, bei dem Schritt (b) bei Raumtemperatur erfolgt.

12. Verfahren nach Anspruch 11, bei dem das Form, Formulierung und Substrat umfassende System im Laufe von Schritt (c) auf eine Temperatur zwischen 40-130°C und bevorzugt zwischen 80-90°C erhitzt wird.

13. Verfahren nach Anspruch 1, bei dem Schritt (d) durch Einwirkung UV-blauer Strahlung, durch ein thermisches Verfahren oder durch eine Kombination davon erfolgt.

14. Verfahren nach Anspruch 13, bei dem Schritt (d) durch Einwirkung UV-blauer Strahlung mit einer Wellenlänge von 200-500 nm in Gegenwart eines Photoinitiators erfolgt.

15. Verfahren nach Anspruch 13, bei dem Schritt (d) durch thermische Behandlung in Gegenwart eines Thermoinitiators bei einer Temperatur unter 135°C erfolgt.

16. Verfahren nach Anspruch 1, bei dem Schritt (e) zeitlich nach mindestens einem thermischen Kreisprozess mechanisch erfolgt.

17. Verfahren nach Anspruch 16, bei dem der thermische Kreisprozess durch erstes Erhitzen auf > 50°C und anschließendes Abkühlen auf < 30°C und bevorzugt durch erstes Erhitzen auf eine Temperatur zwischen 60-100°C und anschließendes Abkühlen auf Raumtemperatur erfolgt.

18. Vorrichtung (5,5', 10) mit mindestens einer auf einem Substrat (3,3') haftenden strukturierten Polymerschicht (4,4'), die sich zur Verwendung im Kontakt mit biologischen Lösungen oder Flüssigkeiten eignet, wobei die strukturierte Polymerschicht (4,4') eine Mikrostruktur aus Rillen oder Näpfchen mit Seitenwänden eines Aspektverhältnisses > 5 umfasst und wobei die mindestens eine auf einem Substrat (3,3') haftende strukturierte Polymerschicht (4,4') durch Polymerisation eines auf Acryl und/oder Epoxid basierenden polymerisationsfähigen Materials nach dem Verfahren gemäß einem der Ansprüche 1-17 hergestellt ist.

19. Vorrichtung nach Anspruch 18, bei der die Oberfläche der strukturierten Polymerschicht über eine nach dem Kontaktwinkelverfahren mit einem Wassertropfen in Kontakt mit der Oberfläche gemessene Benetzbarkeit von ≤ 50° und bevorzugt < 40° verfügt.

20. Vorrichtung nach Anspruch 18, bei der die strukturierte Polymerschicht (4,4') eine Mikrostruktur aus Rillen oder Näpfchen mit Seitenwänden eines Aspektverhältnisses > 10, bevorzugt > 20, umfasst.

21. Vorrichtung nach Anspruch 18, bei der das auf Acryl basierende polymerisationsfähige Material eine Mischung aus mindestens einem Polyoltri(meth)acrylatmonomer und mindestens einem Polyalkylenglykolmono(meth)acrylatmonomer umfasst.

22. Vorrichtung nach Anspruch 21, bei der das Polyoltri(meth)acrylatmonomer ausgewählt ist aus Polyoltri(meth)acrylatethoxylat- und - propoxylatmonomeren.

23. Vorrichtung nach Anspruch 22, bei der das Polyoltri(meth)acrylatmonomer ausgewählt ist aus Trimethylolpropantriacrylatethoxylat (TMPEOTA), Trimethylolpropantriacrylatpropoxylat (TMPPOTA), Pentaerythrittriacrylatethoxylat (PETEOIA), Glyceryltriacrylatpropoxylat (GPTA), Bisphenol-A-trimethacrylatethoxylat und Trimethylolpropantrimethacrylatethoxylat (TMPETMA).

24. Vorrichtung nach Anspruch 21, bei der das Polyalkylenglykolmono(meth)acrylatmonomer ausgewählt ist unter Polypropylenglykolmonomethacrylat, Polyethylenglykolmonomethacrylat, Polyethylenglykolpolypropylenglykolmonomethacrylat, Polypropylenglykolmonoacrylat, Polyethylenglykolmonoacrylat, Polypropylenglykolpolytrimethylenmonoacrylat, Polyethylenglykolpolytetramethylenglykolmonomethacrylat, Methoxypolyethylenglykolmonomethacrylat, Perfluoralkylethylpolyoxyalkylenmonomethacrylat und deren Kombinationen.

25. Vorrichtung nach Anspruch 18, bei der das auf Epoxy basierende polymerisationsfähige Material (i) cycloaliphatische Epoxidharze, (ii) Epoxidharze von Polyphenolglycidylethern, Epoxidharze von Glycidylestern oder deren Mischungen umfasst.

26. Vorrichtung nach Anspruch 25, bei der die cycloaliphatischen Epoxidharze ausgewählt sind unter 2,4-Epoxycyclohexylmethyl-(3,4-epoxy)cyclo-hexancarboxylat, 3,4-Epoxycyclohexylmethyl-(3,4-epoxy)cyclohexancarboxylat, Bis-(3,4-epoxy-6-methylcyclohexylmethyl)adipat, Bis-(3,4-epoxy-cyclohexylmethyl)adipat, Vinylcyclohexendioxid, Bis(2,3-epoxycyclopentyl)etherharz, 2-(3,4-Epoxy)cyclohexyl-5,5-spiro-(3,4-epoxy)cyclohexan-m-dioxan und deren Mischungen.

27. Vorrichtung nach Anspruch 18, bei der das auf Acryl und/oder Epoxy basierende polymerisationsfähige Material bezogen auf das Gesamtgewicht 1-25 Gew.-% mindestens eines Thermoinitiators oder mindestens eines gegenüber UV- und/oder blauer Strahlung empfindlichen Photoinitiators umfasst.

28. Vorrichtung nach Anspruch 27, bei der das auf Acryl basierende polymerisationsfähige Material mindestens einen multifunktionellen Photoinitiator umfasst.

29. Vorrichtung nach Anspruch 27, bei der das auf Epoxy basierende polymerisationsfähige Material mindestens einen kationischen Photoinitiator aus der Reihe aromatische Iodoniumsalze und aromatische Sulfoniumsalze umfasst.

**30.** Vorrichtung nach Anspruch 18, bei der das Substrat aus mindestens einem Material aus der Reihe Silicium, Polymere, Photopolymere und Metalle hergestellt ist.

**Revendications**

**1.** Procédé de production d'une couche polymère modelée (4,4') adhérant à un substrat (3,3'), comprenant les étapes consistant à :

(a) traiter en surface un moule formé précédemment (1,1') avec un inhibiteur de polymérisation,
(b) verser une formulation polymérisable liquide acrylique et/ou époxy (2,2') dans le moule (1,1'),
(c) positionner un substrat (3,3') sur la formulation polymérisable liquide (2,2'),
(d) polymériser la formulation polymérisable liquide (2,2'), et
(e) séparer le moule (1,1') de la couche polymère modelée (4,4').

**2.** Procédé selon la revendication 1, comprenant en outre (f) le traitement de surface du substrat (3,3').

**3.** Procédé selon la revendication 1, dans lequel la formulation polymérisable liquide (2,2') est acrylique, et l'étape (a) comprend la formation d'une couche d'oxygène moléculaire absorbé physiquement sur la surface du moule.

**4.** Procédé selon la revendication 3, dans lequel l'étape (a) comprend un traitement par plasma d'oxygène de faible puissance.

**5.** Procédé selon la revendication 1, dans lequel la formulation polymérisable liquide (2,2') est époxy, et l'étape (a) comprend un traitement avec un plasma d'acides de Lewis, avec des aminosilanes, ou avec l'ammoniac.

**6.** Procédé selon la revendication 2, dans lequel la formulation polymérisable liquide (2,2') est acrylique, et l'étape (f) comprend un traitement par plasma avec de l'azote, un mélange hydrogène-azote, ou des gaz rares.

**7.** Procédé selon la revendication 2, dans lequel la formulation polymérisable liquide (2,2') est époxy, et l'étape (f) comprend un traitement avec un plasma de gaz rares, d'oxygène, de mélange hydrogène-azote ou d'azote.

**8.** Procédé selon la revendication 1, dans lequel le substrat (3,3') est constitué d'un matériau polymère.

**9.** Procédé selon la revendication 8, dans lequel la formulation polymérisable liquide (2,2') comprend au moins un solvant organique choisi parmi les cétones, les alcools, les hydrocarbures et les sulfoxydes.

**10.** Procédé selon la revendication 1, dans lequel l'étape (b) est réalisée à une température comprise entre 30 et 120 °C, de préférence entre 50 et 100 °C, mieux entre 60 et 90 °C.

**11.** Procédé selon la revendication 9, dans lequel l'étape (b) est réalisée à température ambiante.

**12.** Procédé selon la revendication 11 dans lequel, durant l'étape (c), le système comprenant le moule, la formulation et le substrat est chauffé jusqu'à une température comprise entre 40 et 130 °C, de préférence entre 80 et 90 °C.

**13.** Procédé selon la revendication 1, dans lequel l'étape (d) est réalisée par exposition à un rayonnement UV-bleu, par un procédé thermique, ou par une combinaison de ceux-ci.

**14.** Procédé selon la revendication 13, dans lequel l'étape (d) est réalisée par exposition à un rayonnement UV-bleu avec une longueur d'onde de 200-500 nm en présence d'un photoinitiateur.

**15.** Procédé selon la revendication 13, dans lequel l'étape (d) est réalisée par traitement thermique en présence d'un initiateur thermique à une température inférieure à 135 °C.

**16.** Procédé selon la revendication 1, dans lequel l'étape (e) est réalisée mécaniquement après au moins un cycle thermique.

**17.** Procédé selon la revendication 16, dans lequel le cycle thermique est réalisé en chauffant d'abord jusqu'à plus de 50 °C, puis en refroidissant jusqu'à moins de 30 °C, et de préférence en chauffant d'abord jusqu'à une température comprise entre 60 et 100 °C puis en refroidissant jusqu'à température ambiante.

18. Dispositif (5,5',10) comprenant au moins une couche polymère modelée (4,4') adhérant à un substrat (3,3') et étant approprié pour une utilisation en contact avec des solutions ou fluides biologiques, dans lequel la couche polymère modelée (4,4') comprend une microstructure de sillons ou de puits délimités par des parois avec un rapport de forme de plus de 5 et dans lequel l'au moins une couche polymère modelée (4,4') adhérant à un substrat (3,3') est préparée par polymérisation d'un matériau polymérisable acrylique et/ou époxy selon le procédé de l'une quelconque des revendications 1 à 17.

19. Dispositif selon la revendication 18, dans lequel la surface de la couche polymère modelée a une mouillabilité ≤ 50°, de préférence < 40°, mesurée par la méthode de l'angle de contact en utilisant une goutte d'eau en contact avec la surface.

20. Dispositif selon la revendication 18, dans lequel la couche polymère modelée (4,4') comprend une microstructure de sillons ou de puits délimités par des parois avec un rapport de forme de plus de 10, de préférence plus de 20.

21. Dispositif selon la revendication 18, dans lequel le matériau polymérisable acrylique comprend un mélange d'au moins un monomère de tri(méth)acrylate de polyol et au moins un monomère de mono(méth)acrylate de polyalkylène glycol.

22. Dispositif selon la revendication 21, dans lequel le monomère de tri(méth)acrylate de polyol est choisi parmi les monomères de tri(méth)acrylate de polyol éthoxylés et propoxylés.

23. Dispositif selon la revendication 22, dans lequel le monomère de tri(méth)acrylate de polyol est choisi parmi le triacrylate de triméthylolpropane éthoxylé (TMPEOTA), le triacrylate de triméthylolpropane propoxylé (TMPPOTA), le triacrylate de pentaérythritol éthoxylé (PETEOIA), le triacrylate de glycéryle propoxylé (GPTA), le triméthacrylate de bisphénol A éthoxylé, et le triméthacrylate de triméthylolpropane éthoxylé (TMPETMA).

24. Dispositif selon la revendication 21, dans lequel le monomère de mono(méth)acrylate de polyalkylène glycol est choisi parmi le monométhacrylate de polypropylène glycol, le monométhacrylate de polyéthylène glycol, le monométhacrylate de polyéthylène glycol-polypropylène glycol, le monoacrylate de polypropylène glycol, le monoacrylate de polyéthylène glycol, le monoacrylate de polypropylène glycol-polytriméthylène, le monométhacrylate de polyéthylène glycol-polytétraméthylène glycol, le monométhacrylate de méthoxypolyéthylène glycol, le monométhacrylate de perfluoroalkyléthyl-polyoxyalkylène, et les combinaisons de ceux-ci.

25. Dispositif selon la revendication 18, dans lequel le matériau polymérisable époxy comprend (i) des résines époxy cycloaliphatiques, (ii) des résines époxy d'éthers glycidyliques de polyphénol, des résines époxy d'esters glycidyliques, ou des mélanges de celles-ci.

26. Dispositif selon la revendication 25, dans lequel les résines époxy cycloaliphatiques sont choisies parmi le carboxylate de 2,4-époxycyclohexylméthyl-(3,4-époxy)-cyclohexane, le carboxylate de 3,4-époxycyclohexyl-méthyl-(3,4-époxy)cyclohexane, l'adipate de bis(3,4-époxy-6-méthylcyclohexylméthyle), l'adipate de bis(3,4-époxycyclohexylméthyle), le dioxyde de vinylcyclohexène, la résine d'éther de bis(2,3-époxycyclopentyle), le 2-(3,4-époxy)cyclohexyl-5,5-spiro(3,4-époxy)-cyclohexane-m-dioxane, et les mélanges de ceux-ci.

27. Dispositif selon la revendication 18, dans lequel le matériau polymérisable acrylique et/ou époxy comprend 1-25 % en poids, rapporté au poids total, d'au moins un initiateur thermique ou au moins un photoinitiateur sensible au rayonnement UV et/ou bleu.

28. Dispositif selon la revendication 27, dans lequel le matériau polymérisable acrylique comprend au moins un photoinitiateur multifonctionnel.

29. Dispositif selon la revendication 27, dans lequel le matériau polymérisable époxy comprend au moins un photoinitiateur cationique choisi parmi les sels d'iodonium aromatiques et les sels de sulfonium aromatiques.

30. Dispositif selon la revendication 18, dans lequel le substrat est constitué d'au moins un matériau choisi parmi le silicium, les polymères, les phocopolymères, et les métaux.

Fig. 1

(a)

(b)

(c)

(d)

Fig. 2

(a)

(b)

(c)

(d)

EP 2 512 978 B1

Fig. 3

(a)

(b)

EP 2 512 978 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6841339 B
- US 5501893 A
- US 5256360 A
- US 6582890 B


**Non-patent literature cited in the description**

- Cast epoxy-based microfluidic systems and their application in biotechnology. **SETHU P et al.** SENSORS AND ACTUATORS B. ELSEVIER SEQUOIA S.A, vol. 98, 337-346